# DEMANDE DE BREVET EUROPEEN

(11) **EP 3 156 812 A1**
(43) Date de publication de la demande: **19.04.2017**
(21) Numéro de dépôt: 16192685.2
(22) Date de dépôt: 06.10.2016
(51) Int. Cl.: G01R 31/36, G01R 19/165

(54) **SYSTÈME ÉLECTRONIQUE DE CONTRÔLE D'UNE BATTERIE ÉLECTRIQUE**

(30) Priorité: 12.10.2015 FR 1559668
(71) Demandeur: COMMISSARIAT À L'ÉNERGIE ATOMIQUE ET AUX ÉNERGIES ALTERNATIVES, 75015 Paris (FR)
(72) Inventeur: CHATROUX, Daniel, 38470 TECHE (FR); GARNIER, Laurent, 69970 MARENNES (FR); MERCIER, Sylvain, 38120 SAINT-EGREVE (FR)
(74) Mandataire: Thibon, Laurent

(57) **Abrégé**

L'invention concerne un assemblage comportant une batterie (200) et un système de contrôle (220), dans lequel : la batterie (200) comporte au moins trois étages (Eti) en série entre une borne négative (V-) et une borne positive (V+) de la batterie ; et le système de contrôle (220) comporte : au moins deux premiers capteurs de tension (v_{j,j+1}) ayant chacun des premier et deuxième noeuds de mesure reliés par au moins deux étages consécutifs (Etj, Etj+1) de la batterie, lesdits premiers capteurs (v_{j,j+1}) étant agencés de façon que chaque étage (Eti) ait sa borne positive connectée à l'un des premiers capteurs (v_{j,j+1}), et n'ait pas sa borne négative connectée au même premier capteur (v_{j,j+1}) ; et au moins un deuxième capteur de tension (vi) ayant des premier et deuxième noeuds de mesure connectés respectivement à la borne positive et à la borne négative d'un même étage (Eti) de la batterie.

## Description

### Domaine

La présente demande concerne le domaine des batteries électriques de façon générale, et vise plus particulièrement un assemblage comportant une batterie de cellules de stockage d'énergie électrique et un système électronique de contrôle de la batterie.

### Exposé de l'art antérieur

Une batterie électrique est un groupement de plusieurs cellules de stockage d'énergie électrique rechargeables identiques ou similaires (piles, accumulateurs, super-condensateurs, etc.) reliées en série et/ou en parallèle entre deux bornes, respectivement positive et négative, de fourniture d'une tension. Lors de phases de décharge de la batterie, un courant circule de la borne positive vers la borne négative de la batterie, à travers une charge à alimenter. Lors de phases de recharge de la batterie, un chargeur applique un courant de recharge circulant de la borne négative vers la borne positive de la batterie (à travers le chargeur). Une batterie est généralement associée à un système électronique de contrôle adapté à mettre en oeuvre des opérations de contrôle de la recharge, de contrôle de la décharge et/ou d'équilibrage des cellules de la batterie. Il existe un besoin pour un assemblage comportant une batterie électrique et un système électronique de contrôle de la batterie, cet assemblage palliant au moins en partie certains des inconvénients des assemblages existants.

### Résumé

Pour cela, un mode de réalisation prévoit un assemblage comportant une batterie de cellules de stockage d'énergie électrique et un système de contrôle, dans lequel : la batterie comporte au moins trois étages en série entre une borne négative et une borne positive de la batterie, chaque étage comportant une unique cellule ou plusieurs cellules en série et/ou en parallèle entre une borne négative et une borne positive de l'étage ; et le système de contrôle comporte : au moins deux premiers capteurs de tension ayant chacun des premier et deuxième noeuds de mesure reliés par au moins deux étages consécutifs de la batterie, lesdits premiers capteurs étant agencés de façon que chaque étage ait sa borne positive connectée à l'un des premiers capteurs, et n'ait pas sa borne négative connectée au même premier capteur ; et au moins un deuxième capteur de tension ayant des premier et deuxième noeuds de mesure connectés respectivement à la borne positive et à la borne négative d'un même étage de la batterie.

Selon un mode de réalisation, le système de contrôle comporte en outre un circuit de traitement adapté à recevoir les valeurs des tensions mesurées par lesdits capteurs de tension, et à en déduire, par des opérations de soustraction, la valeur de la tension aux bornes de chacun des étages.

Selon un mode de réalisation, chacun des premiers capteurs a ses noeuds de mesure reliés par uniquement deux étages consécutifs de la batterie.

Selon un mode de réalisation, l'assemblage comprend un unique deuxième capteur de tension.

Selon un mode de réalisation, le deuxième capteur de tension est connecté aux bornes d'un étage situé à une extrémité de l'association en série d'étages de la batterie.

Selon un mode de réalisation, l'assemblage comprend uniquement deux deuxièmes capteurs de tension.

Selon un mode de réalisation, les deuxièmes capteurs de tension sont connectés respectivement aux bornes du premier étage et du dernier étage de l'association en série d'étages de la batterie.

Selon un mode de réalisation, le système de contrôle comprend en outre un circuit d'équilibrage comportant, pour chaque premier capteur de tension, un premier module d'équilibrage comprenant des premier et second noeuds de connexion à la batterie connectés respectivement aux premier et second noeuds de mesure du capteur de tension.

Selon un mode de réalisation, chaque module d'équilibrage comprend un transistor en série avec une résistance entre ses premier et second noeuds de connexion à la batterie.

Selon un mode de réalisation, chaque module d'équilibrage comprend un convertisseur DC-DC.

### Brève description des dessins

Ces caractéristiques et leurs avantages, ainsi que d'autres, seront exposés en détail dans la description suivante de modes de réalisation particuliers faite à titre non limitatif en relation avec les figures jointes parmi lesquelles :
la figure 1 est un schéma électrique d'un exemple d'un assemblage comportant une batterie électrique et un système électronique de contrôle de la batterie ;
la figure 2 est un schéma électrique d'un exemple d'un mode de réalisation d'un assemblage comportant une batterie électrique et un système électronique de contrôle de la batterie ;
la figure 3 représente schématiquement un exemple d'agencement des éléments d'un assemblage du type décrit en relation avec la figure 2 ;
la figure 4 est un logigramme illustrant un exemple d'un procédé de contrôle d'une batterie électrique dans un assemblage du type décrit en relation avec la figure 2 ; et
la figure 5 est un logigramme illustrant plus en détail un exemple d'un procédé d'équilibrage des cellules d'une batterie dans un assemblage du type décrit en relation avec la figure 2.

### Description détaillée

De mêmes éléments ont été désignés par de mêmes références aux différentes figures. Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", "latéral", etc., il est fait référence à l'orientation des figures correspondantes, étant entendu que, dans la pratique, les dispositifs décrits peuvent être agencés différemment. Sauf précision contraire, les expressions "approximativement", "sensiblement", et "de l'ordre de" signifient à 10 % près, de préférence à 5 % près. Dans la présente description, on utilise le terme "connecté" pour désigner une liaison électrique directe, sans composant électronique intermédiaire, par exemple au moyen d'une ou plusieurs pistes conductrices et/ou d'un élément de protection normalement conducteur de type fusible, et le terme "couplé" ou le terme "relié", pour désigner soit une liaison électrique directe (signifiant alors "connecté") soit une liaison via un ou plusieurs composants intermédiaires (résistance, diode, condensateur, etc.).

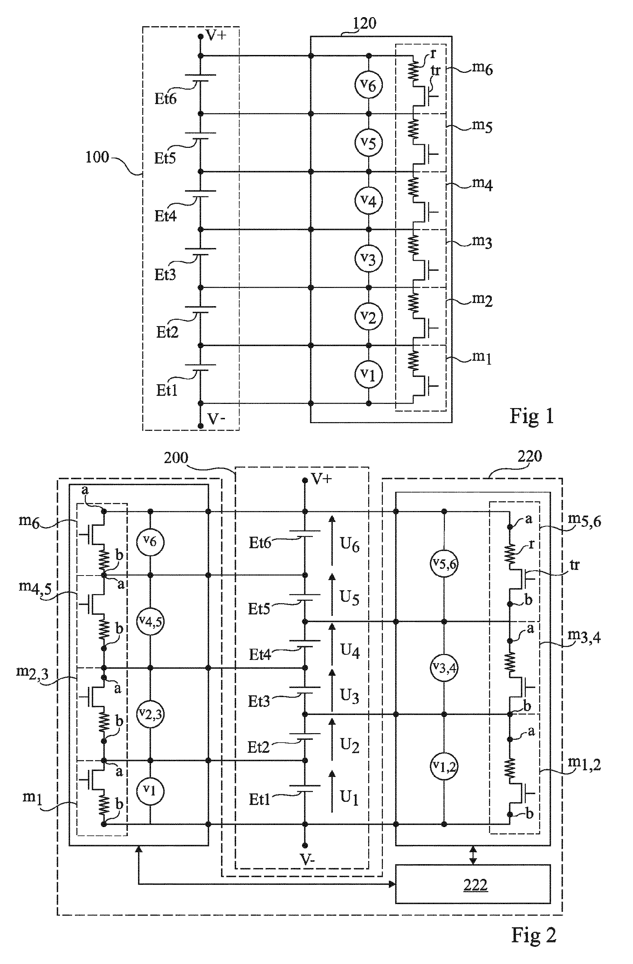

La figure 1 représente un exemple d'un assemblage comportant une batterie 100 et un système électronique 120 de contrôle de la batterie.

Dans l'exemple représenté, la batterie 100 comprend six étages Et1, Et2, Et3, Et4, Et5 et Et6 connectés en série entre une borne négative V- et une borne positive V+ de la batterie. Chaque étage Et1 peut être constitué d'une unique cellule de stockage d'énergie électrique, ou d'une pluralité de cellules connectées en série et/ou en parallèle entre une borne négative et une borne positive de l'étage.

Le système électronique de contrôle 120 de la batterie 100 comprend un circuit de mesure de tension (ou capteur de tension) vᵢ par étage Eti de la batterie, avec i entier allant de 1 à N, et N entier désignant le nombre d'étages de la batterie (N=6 dans l'exemple représenté). Chaque capteur de tension vᵢ est adapté à mesurer la tension aux bornes de l'étage Eti auquel il est associé. Pour cela, chaque capteur de tension vᵢ a un premier noeud de mesure de potentiel bas ou noeud de mesure négatif relié à la borne négative de l'étage Eti, et a un deuxième noeud de mesure de potentiel haut ou noeud de mesure positif relié à la borne positive de l'étage Eti.

Le système de contrôle 120 peut être configuré pour contrôler les opérations de recharge et de décharge de la batterie 100 en tenant compte des valeurs de tension des différents étages Eti mesurées par les capteurs vᵢ. A titre d'exemple, le système de contrôle 120 peut être configuré pour, lors des phases de recharge, surveiller l'état de charge des étages et interrompre la recharge suffisamment tôt pour éviter que les étages ne dépassent un niveau de charge critique au-delà duquel ils pourraient être endommagés, et, lors des phases de décharge, surveiller l'état de charge des étages et interrompre la décharge suffisamment tôt pour éviter que les étages ne dépassent un niveau de décharge critique en deçà duquel ils pourraient être endommagés.

Le système de contrôle 120 peut en outre être adapté à équilibrer les niveaux de charge des différents étages de la batterie en tenant compte des valeurs de tension des différents étages mesurées par les capteurs vᵢ. A cette fin, dans l'exemple représenté, le système de contrôle 120 comprend un circuit d'équilibrage comportant un module d'équilibrage mᵢ par étage Eti de la batterie. Chaque module d'équilibrage mᵢ comprend un transistor tr en série avec une résistance r entre la borne négative et la borne positive de l'étage Eti. Chaque module mᵢ peut être commandé individuellement, par l'intermédiaire de son transistor tr, par un circuit de contrôle non représenté, pour décharger partiellement, par dissipation dans la résistance r, l'étage Eti auquel il est connecté.

Le système de contrôle 120 peut de plus être configuré pour détecter, en tenant compte des valeurs de tension des différents étages fournies par les capteurs vᵢ, d'éventuels défauts de certains étages de la batterie, par exemple une mise en court-circuit ou une mise en circuit ouvert d'une cellule d'un étage de la batterie, et prendre en conséquence des mesures de mise en sécurité telles que l'interruption du courant de recharge ou de décharge de la batterie.

La configuration de la figure 1 présente divers inconvénients. En particulier, la configuration de la figure 1 ne permet pas, en l'état, de détecter un éventuel dysfonctionnement d'un capteur de tension vᵢ du système de contrôle 120. Si un capteur de tension vᵢ du système de contrôle 120 fournit une valeur anormale, le système de contrôle 120 présumera, par précaution, que l'étage Eti est défaillant, et une mise en sécurité de la batterie, potentiellement contraignante pour l'utilisateur, sera mise en oeuvre. Toutefois, dans certains cas, lorsqu'un capteur vᵢ du système de contrôle 120 fournit une valeur anormale, c'est en réalité le capteur lui-même qui est défaillant, et non pas la batterie. Il serait donc souhaitable de pouvoir distinguer une défaillance du système de contrôle de batterie d'une défaillance effective de la batterie, pour pouvoir éviter une procédure contraignante de mise en sécurité de la batterie lorsqu'une telle procédure n'est pas impérative. A titre d'exemple, en cas de défaillance d'un capteur du système de contrôle, on pourrait se contenter d'alerter l'utilisateur du défaut, pour lui permettre de faire réparer à sa convenance le système de contrôle, sans pour autant interrompre le fonctionnement de la batterie.

Une solution pour permettre de différencier une défaillance d'un capteur du système de contrôle de la batterie d'une défaillance effective de la batterie, est de dupliquer l'ensemble des capteurs de tension du système de contrôle, c'est-à-dire de prévoir deux capteurs de tension distincts par étage Eti de la batterie, mesurant tous deux la tension aux bornes de l'étage Eti. En cas d'incohérence entre les mesures fournies par les deux capteurs, on peut en déduire que l'un des capteurs est défaillant. Cette solution présente toutefois un surcoût significatif.

Un autre inconvénient de la configuration de la figure 1 est que chaque capteur de tension vᵢ doit être connecté aux deux bornes de l'étage Eti auquel il est associé, lesquelles bornes peuvent être relativement éloignées l'une de l'autre. Il en résulte que la longueur de fil conducteur ou de piste conductrice nécessaire pour connecter le système de contrôle 120 à la batterie 100 est relativement élevée.

La figure 2 représente un exemple d'un mode de réalisation d'un assemblage comportant une batterie 200 et un système électronique 220 de contrôle de la batterie 200.

Dans l'exemple représenté, la batterie 200 est identique ou similaire à la batterie 100 de l'assemblage de la figure 1. En particulier, la batterie 200 comprend six étages Et1, Et2, Et3, Et4, Et5 et Et6 connectés en série entre une borne négative V- et une borne positive V+ de la batterie. Chaque étage Eti peut être constitué d'une unique cellule de stockage d'énergie électrique, ou d'une pluralité de cellules connectées en série et/ou en parallèle entre une borne négative et une borne positive de l'étage. A titre d'exemple, les étages Eti de la batterie 200 ont tous la même tension nominale de pleine charge, et la même capacité nominale de stockage de charges. Les différents étages Eti de la batterie 200 sont par exemple identiques aux dispersions de fabrication près. Les modes de réalisation décrits ne se limitent toutefois pas à ces cas particuliers. De plus les modes de réalisation décrits peuvent s'appliquer à des batteries comportant un nombre N d'étages en série différent de 6. Plus généralement, les modes de réalisation décrits s'appliquent quel que soit le nombre N d'étages Eti en série supérieur ou égal à 3. On considère ici, comme cela est représenté sur la figure 2, que les étages Et1 à EtN sont reliés en série par ordre d'indice croissant, l'étage Et1 ayant sa borne négative connectée à la borne négative V- de la batterie, et l'étage EtN ayant sa borne positive connectée à la borne positive V+ de la batterie.

Le système électronique de contrôle 220 de la batterie 200 comprend N-1 (soit 5 dans l'exemple représenté) circuits de mesure de tension ou capteurs de tension v_{j,j+1}, avec j entier allant de 1 à N-1. Chaque capteur de tension v_{j,j+1} est adapté à mesurer la tension aux bornes de l'association en série des deux étages adjacents Etj et Etj+1. Pour cela, chaque capteur de tension v_{j,j+1} a un premier noeud de mesure de potentiel bas ou noeud de mesure négatif relié à la borne négative de l'étage Etj, et un deuxième noeud de mesure de potentiel haut ou noeud de mesure positif relié à la borne positive de l'étage Etj+1. Ainsi, chaque étage Eti de la batterie a sa borne positive reliée à l'un des capteurs de tension v_{j,j+1}, et a sa borne négative non reliée à ce même capteur. De même, chaque étage Eti de la batterie a sa borne négative reliée à l'un des capteurs de tension v_{j,j+1}, et a sa borne positive non reliée à ce même capteur.

Le système électronique de contrôle 220 de la batterie 200 comprend en outre au moins un capteur de tension vᵢ adapté à mesurer la tension aux bornes d'un unique étage Eti de la batterie, c'est-à-dire ayant ses noeuds de mesure de potentiel bas et de potentiel haut reliés respectivement à la borne négative et à la borne positive d'un même étage Eti. Dans l'exemple représenté, le système de contrôle 220 comprend deux capteurs de tension v₁ et v_{N} connectés respectivement aux bornes de l'étage Et1 et aux bornes de l'étage EtN. A titre de variante, l'un des deux capteurs de tension v₁ et v_{N} peut être omis. A titre de variante, le système de contrôle peut ne comporter ni le capteur v₁ ni le capteur v_{N}, mais comporter un capteur de tension vᵢ connecté aux bornes d'un étage Eti de rang intermédiaire entre 1 et N. A titre d'exemple, le système de contrôle 220 ne comprend pas plus de deux capteurs de tension vᵢ connectés aux bornes d'étages Eti uniques (y compris lorsque N est supérieur à 3).

Le système de contrôle 220 comporte en outre un circuit de traitement et de contrôle 222 adapté à recevoir les valeurs des tensions mesurées par les capteurs v_{j,j+1} et par le ou les capteurs vᵢ, et à en déduire, par des opérations de soustraction, les valeurs des tensions aux bornes de chacun des étages de la batterie. Le circuit 222 comprend par exemple une unité de calcul numérique, par exemple un microprocesseur, recevant sous forme numérique les valeurs de tension mesurées par les capteurs de tension. Pour cela, chaque capteur de tension peut inclure un convertisseur analogique-numérique, ou être relié à l'unité de calcul numérique par l'intermédiaire d'un convertisseur analogique-numérique.

Dans l'exemple représenté, la tension U₁ aux bornes de l'étage Et1 peut être fournie par le capteur v₁. Connaissant la tension U₁, la tension U₂ aux bornes de l'étage Et2 peut être déterminée en soustrayant la tension U₁ à la tension fournie par le capteur v_{1,2}. Connaissant la tension U₂, la tension U₃ aux bornes de l'étage Et3 peut être déterminée en soustrayant la tension U₂ à la tension fournie par le capteur v_{2,3}. Connaissant la tension U₃, la tension U₄ aux bornes de l'étage Et3 peut être déterminée en soustrayant la tension U₃ à la tension fournie par le capteur v_{3,4}. Connaissant la tension U₄, la tension U₅ aux bornes de l'étage Et5 peut être déterminée en soustrayant la tension U₄ à la tension fournie par le capteur v_{4,5}. Enfin, connaissant la tension U₅, la tension U₆ aux bornes de l'étage Et6 peut être déterminée en soustrayant la tension U₅ à la tension fournie par le capteur v_{5,6}.

Plus généralement, quelle que soit sa position dans la batterie, un seul capteur de tension vᵢ connecté aux bornes d'un étage Eti unique de la batterie, suffit pour pouvoir remonter aux tensions individuelles Uᵢ de chacun des étages de la batterie à partir des valeurs de tension mesurées par les capteurs v_{j,j+1}.

Un avantage de la configuration de la figure 2 est qu'elle permet, dans une certaine mesure, de détecter des défauts des capteurs de tension du système de contrôle. Par exemple, si le capteur v₁ fournit une valeur de tension anormalement élevée, par exemple supérieure à deux fois la tension nominale de pleine charge d'un étage, mais que le capteur v_{1,2} fournit une tension inférieure à cette valeur, on peut en déduire qu'au moins l'un des capteurs v₁ et v_{1,2} est défaillant. Plus généralement, ayant déterminé la tension Uj aux bornes d'un étage Etj de la batterie, si la valeur de tension fournie par le capteur v_{j,j+1} ou par le capteur v_{j-1,j} est inférieure à la tension Uⱼ, on peut en déduire qu'au moins un capteur de tension du système de contrôle est défaillant.

Dans l'exemple représenté, la prévision de deux capteurs de tension v₁ et v_{N} connectés respectivement aux bornes des étages extrêmes Et1 et EtN de la batterie, permet d'introduire un niveau de redondance supplémentaire (par rapport à une configuration comportant un seul capteur de tension vᵢ connecté aux bornes d'un étage unique Eti de la batterie), et d'augmenter encore les possibilités de détection de défaillance des capteurs de tension du système de contrôle. En particulier, dans l'exemple de la figure 6, le circuit 222 peut vérifier la cohérence des mesures fournies par les différents capteurs de tension en comparant la somme des valeurs de tension mesurées par les capteurs v_{1,2}, v_{3,4} et v_{5,6}, à la somme des valeurs de tension mesurées par les capteurs v₁, v_{2,3}, v_{4,5} et v₆. Si les deux sommes ne sont pas identiques (aux imprécisions de mesure près), on peut en déduire qu'au moins l'un des capteurs de tension est défaillant. De plus, le circuit 222 peut vérifier la cohérence entre la valeur de la tension U₆ estimée par soustraction de la tension U₅ à la tension fournie par le capteur v_{5,6}, et la valeur de la tension U₆ mesurée par le capteur v₆.

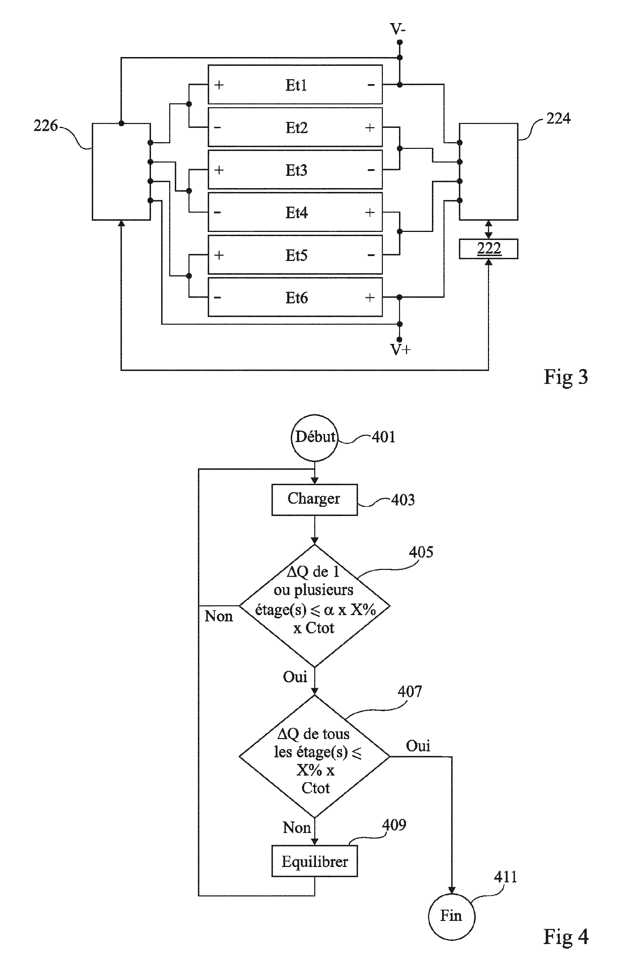

Un autre avantage de la configuration de la figure 2 réside dans le fait que les noeuds de mesure d'un même capteur de tension v_{j,j+1} ne sont pas connectés aux deux bornes d'un même étage de la batterie, mais sont connectés respectivement à la borne négative d'un premier étage Etj et à la borne positive d'un deuxième étage Etj+1 adjacent au premier étage, lesquelles bornes étant généralement voisines l'une de l'autre, comme cela est illustré par la figure 3 décrite ci-après. Il en résulte une diminution de la longueur totale de fil conducteur ou de piste conductrice nécessaire pour connecter le système de contrôle à la batterie par rapport à une configuration du type décrit en relation avec la figure 1.

La figure 3 représente schématiquement un exemple d'agencement des éléments d'un assemblage du type décrit en relation avec la figure 2. Dans cet exemple, chaque étage Eti de la batterie est constitué d'un unique accumulateur de forme générale cylindrique, dont les bornes de connexion négative et positive sont disposées respectivement sur les deux extrémités du cylindre, c'est-à-dire sur les deux faces parallèles opposées du cylindre orthogonales à son axe longitudinal. Les accumulateurs Et1, Et2, Et3, Et4, Et5, Et6 sont alignés de façon que leurs axes longitudinaux respectifs soient sensiblement horizontaux, et que leurs extrémités respectives soient disposées dans deux plans sensiblement verticaux. Les accumulateurs Et1, Et2, Et3, Et4, Et5, Et6 sont disposés alternativement tête bêche, c'est-à-dire de façon que chaque accumulateur Etj ait sa borne positive dans le même plan vertical que la borne négative de l'accumulateur Etj+1, et ait sa borne négative dans le même plan vertical que la borne positive de l'accumulateur Etj+1.

Ainsi, dans l'exemple de la figure 3, chaque capteur de tension v_{j,j+1} a ses noeuds de mesure négatif et positif connectés à des bornes situées d'un même côté de l'ensemble d'accumulateurs, ce qui permet de limiter la longueur des fils ou pistes de connexion. Plus particulièrement, dans cet exemple, les capteurs v_{1,2}, v_{3,4} et v_{5,6} (figure 2) sont disposés du côté droit de l'ensemble d'accumulateurs, et les capteurs v_{2,3} et v_{4,5} (figure 2) sont disposés du côté gauche de l'ensemble d'accumulateurs. Dans cet exemple, seuls les capteurs v₁ et v₆ (figure 2) ont leurs noeuds de mesure connectés de part et d'autre de l'ensemble d'accumulateurs. A titre d'exemple, les capteurs v_{1,2}, v_{3,4} et v_{5,6} peuvent être intégrés dans une même puce de circuits intégrés 224 disposée du côté droit de l'ensemble d'accumulateurs, et les capteurs v₁, v_{2,3}, v_{4,5} et v₆ peuvent être intégrés dans une même puce de circuits intégrés 226 distincte de la puce 224, disposée du côté gauche de l'ensemble d'accumulateurs. Le circuit de traitement et de contrôle 222 peut être intégré à l'une des puces 224 et 226, ou être formé dans une puce distincte.

Le système de contrôle 220 de l'assemblage de la figure 2 peut être adapté à réaliser diverses opérations en tenant compte des valeurs des tensions Uᵢ des étages Eti déterminées par le circuit de traitement et de contrôle 222. En particulier, le système de contrôle 220 peut être configuré pour contrôler, en tenant compte des valeurs des tensions Uᵢ, les phases de recharge et de décharge de la batterie 200, et interrompre la recharge ou la décharge suffisamment tôt pour éviter que les étages ne dépassent un niveau de charge critique ou un niveau de décharge critique. De plus, le système de contrôle 220 peut être adapté à détecter, en tenant compte des tensions Uᵢ, d'éventuels défauts de certaines cellules de la batterie, et prendre en conséquence des mesures de mise en sécurité telles que l'interruption du courant de recharge ou de décharge de la batterie. En outre, le système de contrôle 220 peut être adapté à équilibrer les niveaux de charge des différents étages Eti de la batterie en tenant compte des valeurs des tensions Uᵢ.

### Equilibrage

Des exemples de circuits et méthodes d'équilibrage adaptés à une configuration du type décrit en relation avec la figure 2 vont maintenant être décrits.

Dans un premier exemple de réalisation (non représenté), le système de contrôle 220 comprend un circuit d'équilibrage identique ou similaire à celui du système de contrôle 120 de la figure 1, c'est-à-dire comportant un module d'équilibrage mᵢ par étage Eti de la batterie, chaque module d'équilibrage mᵢ pouvant être commandé individuellement par un circuit de contrôle, par exemple le circuit 222, en tenant compte des valeurs des tensions Uᵢ des différents étages déterminées à partir des mesures fournies par les capteurs de tension.

Cette solution présente l'avantage d'être simple à mettre en oeuvre, et compatible avec les méthodes d'équilibrage des assemblages du type décrit en relation avec la figure 1. Toutefois, un inconvénient de cette solution est qu'elle implique de prévoir des connexions supplémentaires entre le système de contrôle 220 et la batterie.

Dans un autre exemple de réalisation illustré par la figure 2, le circuit d'équilibrage du système de contrôle 220 comprend un module d'équilibrage par capteur de tension, connecté aux mêmes noeuds de la batterie que le capteur de tension correspondant. Ainsi, le circuit d'équilibrage du système de contrôle 220 comprend N-1 modules d'équilibrage m_{j,j+1}, chaque module m_{j,j+1} étant connecté aux bornes de l'association en série des étages adjacents Etj et Etj+1. Dans l'exemple représenté, le circuit d'équilibrage du système de contrôle 220 comprend en outre deux modules d'équilibrage m₁ et m_{N}, connectés respectivement aux bornes de l'étage Et1 et aux bornes de l'étage EtN. Dans cet exemple, les modules d'équilibrage sont des modules de type dissipatif, commandables individuellement pour décharger le ou les étages de la batterie aux bornes desquels ils sont connectés. Plus particulièrement, dans cet exemple, chaque module d'équilibrage comprend deux noeuds a et b de connexion du module d'équilibrage à la batterie (par exemple confondus avec les noeuds de mesure du capteur de tension correspondant), et, entre ses noeuds a et b, une association en série d'une résistance r et d'un transistor de commande tr.

Un avantage du circuit d'équilibrage de la figure 2 est qu'il ne nécessite pas de connexions entre le système de contrôle 220 et la batterie, autres que les connexions requises pour connecter les capteurs de tension à la batterie.

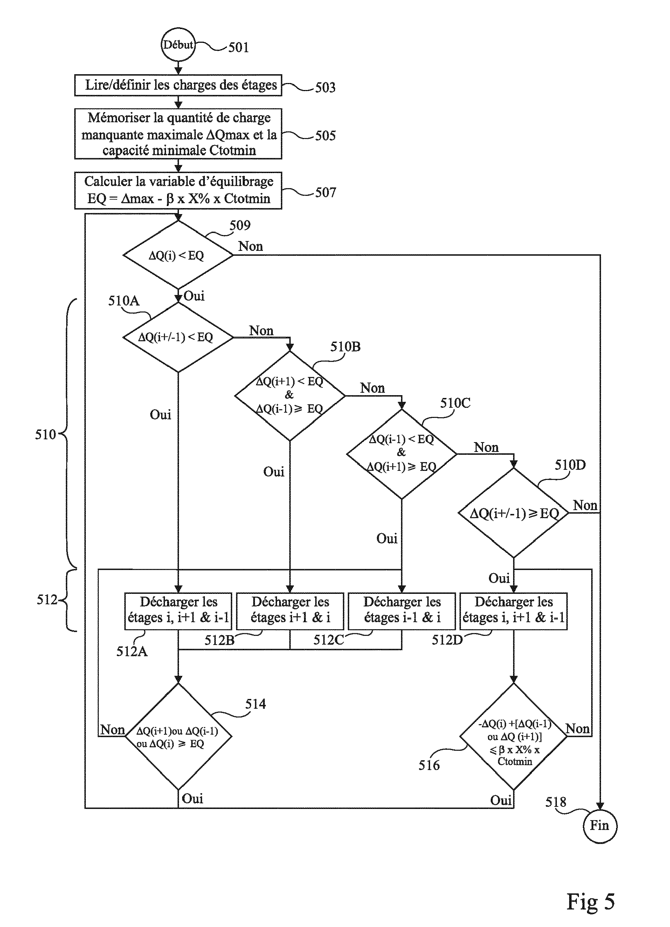

Un exemple de méthode de commande d'un circuit d'équilibrage du type représenté en figure 2 va maintenant être décrit en relation avec les figures 4 et 5. Dans cet exemple, on considérera que le système de contrôle 220 de la batterie peut connaître à tout instant la quantité de charges contenue dans chaque étage Eti de la batterie, ainsi que la capacité totale de stockage de charges de chaque étage Eti de la batterie (étant entendu que la capacité totale de stockage de charges d'un étage est susceptible de varier avec le vieillissement de la batterie). Pour cela, le système de contrôle 220 de la batterie peut comporter, outre les capteurs de tension décrits ci-dessus, des capteurs de courant et/ou des compteurs de charges, non représentés. La méthode de contrôle décrite ci-après pourra toutefois être adaptée à un mode de contrôle simplifié dans lequel les quantités de charges contenues dans les différents étages Eti sont approximées par les tensions Uᵢ aux bornes des étages Eti, et dans lequel les capacités totales de stockage de charges des différents étages Eti sont considérées comme étant constantes dans le temps, et sont approximées par les tensions nominales de pleine charge des étages Eti.

La figure 4 représente, sous forme de blocs, un exemple d'un procédé de recharge de la batterie 200 incluant un équilibrage des étages Eti en fin de charge, mis en oeuvre par le système de contrôle 220 de la batterie dans un assemblage du type décrit en relation avec la figure 2.

Le bloc 401 ("Début") de la figure 4 représente le démarrage de la phase de recharge.

Lors d'une étape 403 ("Charger") le système de contrôle 220 commande l'application d'un courant de recharge dans la batterie.

Lors d'une étape 405 ("ΔQ de 1 ou plusieurs étage(s) ≤ α*X%*Ctot"), parallèlement à l'étape 403 de recharge de la batterie, le système de contrôle 220 vérifie, par exemple de façon continue ou de façon périodique, si, dans au moins un étage Eti de la batterie, la quantité de charges manquante ΔQ pour atteindre la pleine charge de l'étage est inférieure ou égale à α*X%*Ctot, où Ctot désigne la capacité totale de stockage de charges de l'étage Eti, où X est un pourcentage, par exemple compris entre 1 et 5%, définissant la précision d'équilibrage visée, et où α est un coefficient de paramétrage inférieur ou égal à 1, par exemple de l'ordre de 0,1, permettant, lorsqu'il est inférieur à 1, d'obtenir une convergence plus rapide de l'équilibrage. On considère ici que la batterie est chargée et équilibrée lorsque, dans chacun des étages Eti de la batterie, la quantité de charges manquantes ΔQ dans l'étage est inférieure à X%*Ctot, où Ctot désigne la capacité totale de stockage de charges de l'étage Eti.

Si aucun des étages Eti de la batterie ne remplit la condition vérifiée à l'étape 405 ("Non"), l'étape 403 de recharge de la batterie se poursuit.

Si au moins un étage Eti de la batterie remplit la condition vérifiée à l'étape 405 ("Oui"), l'étape 403 est interrompue, c'est-à-dire que le courant de recharge de la batterie est interrompu.

Le système de contrôle 220 vérifie alors, lors d'une étape 407 ("ΔQ de tous les étages ≤ X%*Ctot"), si, dans chaque étage Eti de la batterie, la quantité de charges manquante ΔQ pour atteindre la pleine charge de l'étage est inférieure ou égale à X% de la capacité totale de stockage de charges de l'étage.

Si la condition vérifiée à l'étape 407 n'est pas remplie ("Non"), un équilibrage de la batterie est mis en oeuvre lors d'une étape 409 ("Equilibrer"). Le procédé d'équilibrage mis en oeuvre lors de l'étape 409 sera décrit plus en détail ci-après en relation avec la figure 5. A l'issue de l'étape d'équilibrage 409, le procédé de recharge reprend à partir de l'étape 403, c'est-à-dire que le courant de recharge de la batterie est à nouveau appliqué.

Si la condition vérifiée à l'étape 407 est remplie ("Oui"), cela signifie que tous les étages Eti de la batterie sont chargés et équilibrés, et le procédé de recharge se termine.

Le bloc 411 ("Fin") de la figure 4 représente la fin de la phase de recharge.

La figure 5 représente, sous forme de blocs, un exemple de mise en oeuvre de l'étape d'équilibrage 409 du procédé de recharge de la figure 4.

Les étages Eti de la batterie étant parcourus par un même courant de recharge, on cherche, lors de l'étape d'équilibrage 409, à ramener sensiblement à une même valeur les quantités de charges manquantes ΔQ dans les différents étages Eti, pour maximiser les chances d'atteindre l'équilibrage lors de l'itération suivante des étapes 403 à 407.

Le bloc 501 ("Début") de la figure 5 représente le début de la phase d'équilibrage 409.

Lors d'une étape 503 ("Lire/définir les charges des étages"), les quantités de charges contenues dans les différents étages Eti sont déterminées.

Lors d'une étape suivante 505 ("Mémoriser la quantité de charges manquante maximale ΔQmax et la capacité minimale Ctotmin"), le système de contrôle détermine et mémorise la quantité de charges manquante ΔQmax dans l'étage Eti le plus éloigné de son niveau de pleine charge, et la capacité totale de stockage de charges Ctotmin de l'étage Eti ayant la plus petite capacité de stockage de charges.

Lors d'une étape suivante 507 ("Calculer la variable d'équilibrage EQ=ΔQmax-β*X%*Ctotmin"), le système d'équilibrage calcule la valeur d'une variable d'équilibrage EQ=ΔQmax-β*X%*Ctotmin, où β est un coefficient de paramétrage inférieur à 1 (éventuellement nul), par exemple de l'ordre de 0,5. La variable d'équilibrage EQ correspond, en première approximation, à la quantité de charges à retirer dans l'étage le plus chargé de la batterie lors de la phase d'équilibrage 409. Le terme β*X%*Ctotmin (lorsque le coefficient β n'est pas nul) permet d'accélérer la convergence de l'équilibrage en prenant en compte le fait que l'étage ayant la plus petite capacité totale de stockage de charges a des chances d'atteindre son niveau de pleine charge plus rapidement que les autres, et en prenant en compte la condition de fin d'équilibrage (ΔQ ≤ X%*Ctot dans tous les étages).

Pour chaque étage Eti de la batterie, le système de contrôle détermine ensuite, lors d'une étape 509 ("ΔQ(i)<EQ"), si la quantité de charges manquante ΔQ(i) dans l'étage Eti est inférieure à la variable d'équilibrage EQ.

Si ce n'est pas le cas ("Non"), l'étage Eti n'est pas directement concerné par l'équilibrage.

Si c'est le cas ("Oui"), l'étage Eti est directement concerné par l'équilibrage. Le système de contrôle détermine alors dans laquelle des quatre configurations 510A, 510B, 510C et 510D suivantes se trouve la batterie :
510A ("ΔQ(i+/-1)<EQ"): les quantités de charges manquantes ΔQ(i-1) et ΔQ(i+1) des étages Eti-1 et Eti+1 sont toutes deux inférieures à la variable d'équilibrage EQ ;
510B ("ΔQ(i+1)<EQ & ΔQ(i-1)≥EQ"): la quantité de charges manquantes ΔQ(i+1) de l'étage Eti+1 est inférieure à la variable d'équilibrage EQ, et la quantité de charges manquantes ΔQ(i-1) de l'étage Eti-1 est supérieure ou égale à la variable d'équilibrage EQ ;
510C ("ΔQ(i-1)<EQ & ΔQ(i+1)≥EQ"): la quantité de charges manquantes ΔQ(i-1) de l'étage Eti-1 est inférieure à la variable d'équilibrage EQ, et la quantité de charges manquantes ΔQ(i+1) de l'étage Eti+1 est supérieure ou égale à la variable d'équilibrage EQ ; et
510D ("ΔQ(i+/-1)ΔEQ"): les quantités de charges manquantes ΔQ(i-1) et ΔQ(i+1) des étages Eti-1 et Eti+1 sont toutes deux supérieures ou égales à la variable d'équilibrage EQ.

Lors d'une étape 512 suivant l'étape 510, l'équilibrage proprement dit de l'étage Eti et du ou des étages voisins Eti-1 et Eti+1 est réalisé. On notera que pour les étages Eti de rang i=1 ou i=N, les étages Eti-1, respectivement Eti+1, n'existent pas et ne sont donc pas considérés ni équilibrés.

Si la batterie se trouve dans la configuration 510A, le système de contrôle 220 commande, lors d'une étape 512A ("Décharger les étages i, i+1 & i-1"), la décharge des étages Eti, Eti+1 et Eti-1. La décharge des étages Eti et Eti+1 peut être effectuée par le module d'équilibrage m_{i,i+1}, et la décharge des étages Eti et Eti-1 peut être effectuée par le module d'équilibrage m_{i-1,i}.

Si la batterie se trouve dans la configuration 510B, le système de contrôle 220 commande, lors d'une étape 512B ("Décharger les étages i+1 & i"), la décharge des étages Eti+1 et Eti. La décharge des étages Eti+1 et Eti peut être effectuée par le module d'équilibrage m_{i,i+1}.

Si la batterie se trouve dans la configuration 510C, le système de contrôle 220 commande, lors d'une étape 512C ("Décharger les étages i-1 & i"), la décharge des étages Eti-1 et Eti. La décharge des étages Eti-1 et Eti peut être effectuée par le module d'équilibrage m_{i,i-1}.

Si la batterie se trouve dans la configuration 510D, le système de contrôle 220 commande, lors d'une étape 512D ("Décharger les étages i, i+1 & i-1"), la décharge des étages Eti, Eti-1 et Eti+1. La décharge des étages Eti et Eti+1 peut être effectuée par le module d'équilibrage m_{i,i+1}, et la décharge des étages Eti et Eti-1 peut être effectuée par le module d'équilibrage m_{i-1,i}.

Après l'étape 512A, 512B ou 512C, le système de contrôle 220 détermine, lors d'une étape 514 ("ΔQ(i+1) ou ΔQ(i-1) ou ΔQ(i)≥EQ"), si la quantité de charges manquantes ΔQ dans l'un des étages en cours de décharge a atteint la variable d'équilibrage EQ. Si ce n'est pas le cas ("Non"), l'étape de décharge 512A, 512B ou 512C initiée se poursuit. Si la quantité de charges manquantes ΔQ dans l'un des étages en cours de décharge a atteint la variable d'équilibrage EQ ("Oui"), le procédé d'équilibrage reprend à partir de l'étape 509.

Après l'étape 512D, le système de contrôle 220 détermine, lors d'une étape 516 ("-ΔQ(i)+[ΔQ(i-1) ou ΔQ(i+1)]≤β*X%*Ctotmin"), si la différence entre la quantité de charges manquantes ΔQ(i-1) dans l'étage Eti-1 et la quantité de charges manquantes ΔQ(i) dans l'étage Eti, ou la différence entre la quantité de charges manquantes ΔQ(i+1) dans l'étage Eti+1 et la quantité de charges manquantes ΔQ(i) dans l'étage Eti, est inférieure au terme β*X%*Ctotmin. Si c'est le cas ("Oui"), le procédé d'équilibrage reprend à partir de l'étape 509. Si ce n'est pas le cas ("Non"), l'étape de décharge 512D des étages Eti, Eti+1 et Eti-1 se poursuit.

Lors de l'étape 509, si aucun des étages Eti de la batterie n'est concerné par l'équilibrage, c'est-à-dire si la quantité de charges manquantes dans chacun des étages Eti est supérieure ou égale à la variable d'équilibrage EQ, la phase d'équilibrage se termine.

Le bloc 518 ("Fin") de la figure 5 représente la fin de la phase d'équilibrage.

Des modes de réalisation particuliers ont été décrits. Diverses variantes et modifications apparaîtront à l'homme de l'art. En particulier, les modes de réalisation décrits ne se limitent pas aux exemples de circuits et méthodes d'équilibrage décrits en relation avec les figures 2, 4 et 5. Les modes de réalisation décrits peuvent notamment être adaptés à la mise en oeuvre d'un équilibrage dit actif, c'est-à-dire dans lequel on ne se contente pas de dissiper le surplus d'énergie dans les étages les plus chargés, mais l'on réalise des transferts d'énergie entre les étages les plus chargés et les étages les moins chargés. A titre d'exemple, les modules d'équilibrages dissipatifs m_{j,j+1} du circuit d'équilibrage de la figure 2 peuvent être remplacés par des modules d'équilibrage actifs. Chaque module d'équilibrage actif comporte par exemple un convertisseur DC-DC connecté entre les noeuds a et b du module. A titre d'exemple, chaque module d'équilibrage actif comporte un transformateur comportant un premier enroulement conducteur entre les noeuds a et b du module et un second enroulement conducteur secondaire couplé magnéti-quement au premier enroulement, entre les bornes V- et V+ de la batterie. Un avantage d'une telle configuration est que les convertisseurs DC-DC voient alors des tensions plus élevées que dans une configuration dans laquelle chaque module d'équilibrage est connecté aux bornes d'un étage unique de la batterie. Il en résulte un meilleur rendement de conversion lors de l'équilibrage.

Par ailleurs, les modes de réalisation décrits ne se limitent pas à l'exemple particulier décrit en relation avec la figure 2 dans lequel les capteurs de tension du système de contrôle ont leurs noeuds de mesure reliés par deux étages adjacents de la batterie. A titre de variante, on peut prévoir d'entrelacer des capteurs de tension du système de contrôle de façon que chaque capteur mesure la tension aux bornes d'une association en série de trois étages adjacents de la batterie, ou d'un nombre d'étages adjacents supérieur à trois.

## Revendications

1. Assemblage comportant une batterie (200) de cellules de stockage d'énergie électrique et un système de contrôle (220), dans lequel :
la batterie (200) comporte au moins trois étages (Eti) en série entre une borne négative (V-) et une borne positive (V+) de la batterie, chaque étage (Eti) comportant une unique cellule ou plusieurs cellules en série et/ou en parallèle entre une borne négative et une borne positive de l'étage ; et
le système de contrôle (220) comporte :
au moins deux premiers capteurs de tension (v_{j,j+1}), chaque premier capteur ayant des premier et deuxième noeuds de mesure reliés par au moins deux étages consécutifs (Etj, Etj+1) de la batterie et étant adapté à mesurer la tension aux bornes de l'association en série desdits au moins deux étages consécutifs (Etj, Etj+1), lesdits premiers capteurs (v_{j,j+1}) étant agencés de façon que chaque étage (Eti) ait sa borne positive connectée à l'un des premiers capteurs (v_{j,j+1}), et n'ait pas sa borne négative connectée au même premier capteur (v_{j,j+1}) ; et
au moins un deuxième capteur de tension (vᵢ) ayant des premier et deuxième noeuds de mesure connectés respectivement à la borne positive et à la borne négative d'un même étage (Eti) de la batterie et étant adapté à mesurer la tension aux bornes de cet étage.

2. Assemblage selon la revendication 1, dans lequel le système de contrôle (220) comporte en outre un circuit de traitement (222) configuré pour recevoir les valeurs des tensions mesurées par lesdits capteurs de tension (v_{j,j+1}, vᵢ), et à en déduire, par des opérations de soustraction, la valeur de la tension (Ui) aux bornes de chacun des étages (Eti).

3. Assemblage selon la revendication 1 ou 2, dans lequel chacun des premiers capteurs (v_{j,j+1}) a ses noeuds de mesure reliés par uniquement deux étages consécutifs (Etj, Etj+1) de la batterie.

4. Assemblage selon l'une quelconque des revendications 1 à 3, comprenant un unique deuxième capteur de tension (v₁).

5. Assemblage selon la revendication 4, dans lequel ledit deuxième capteur de tension (v₁) est connecté aux bornes d'un étage (Et1) situé à une extrémité de l'association en série d'étages (Eti) de la batterie.

6. Assemblage selon l'une quelconque des revendications 1 à 3, comprenant uniquement deux deuxièmes capteurs de tension (v₁, v_{N}).

7. Assemblage selon la revendication 6, dans lequel lesdits deuxièmes capteurs de tension (v₁, v_{N}) sont connectés respectivement aux bornes du premier étage (Et1) et du dernier étage (EtN) de l'association en série d'étages (Eti) de la batterie.

8. Assemblage selon l'une quelconque des revendications 1 à 7, dans lequel le système de contrôle (220) comprend en outre un circuit d'équilibrage comportant, pour chaque premier capteur de tension (v_{j,j+1}), un premier module d'équilibrage (m_{j,j+1}) comprenant des premier (a) et second (b) noeuds de connexion à la batterie connectés respectivement aux premier et second noeuds de mesure du capteur de tension (v_{j,j+1}).

9. Assemblage selon la revendication 8, dans lequel chaque module d'équilibrage (m_{j,j+1}) comprend un transistor (tr) en série avec une résistance (r) entre ses premier (a) et second (b) noeuds de connexion à la batterie.

10. Assemblage selon la revendication 8, dans lequel chaque module d'équilibrage (m_{j,j+1}) comprend un convertisseur DC-DC.
